(19) Europäisches Patentamt / European Patent Office / Office européen des brevets

(11) **EP 2 553 802 B1**

(12) **EUROPÄISCHE PATENTSCHRIFT**

(45) Veröffentlichungstag und Bekanntmachung des Hinweises auf die Patenterteilung:
**22.01.2014 Patentblatt 2014/04**

(21) Anmeldenummer: **11712478.4**

(22) Anmeldetag: **29.03.2011**

(51) Int Cl.:
*H02P 21/00* (2006.01)   *G01R 31/34* (2006.01)
*G06F 17/50* (2006.01)   *H02P 21/14* (2006.01)
*H02P 25/02* (2006.01)

(86) Internationale Anmeldenummer:
**PCT/EP2011/001569**

(87) Internationale Veröffentlichungsnummer:
**WO 2011/124346 (13.10.2011 Gazette 2011/41)**

(54) **VERFAHREN ZUM ANSTEUERN EINES OPTIMALEN BETRIEBSPUNKTES BEI EINER SYNCHRONMASCHINE UND EINE UMRICHTERGESPEISTE SYNCHRONMASCHINE**

METHOD FOR CONTROLLING AN OPTIMAL OPERATING POINT IN A SYNCHRONOUS MACHINE AND INVERTER-FED SYNCHRONOUS MACHINE

PROCÉDÉ DE COMMANDE D'UN POINT DE FONCTIONNEMENT OPTIMAL SUR UNE MACHINE SYNCHRONE ET MACHINE SYNCHRONE ALIMENTÉE PAR UN CONVERTISSEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **31.01.2011 DE 102011009935**
**30.03.2010 DE 102010013463**

(43) Veröffentlichungstag der Anmeldung:
**06.02.2013 Patentblatt 2013/06**

(73) Patentinhaber: **Sew-Eurodrive GmbH & Co. KG**
**76646 Bruchsal (DE)**

(72) Erfinder:
• **REINHARDT, Volkmar**
  **69124 Heidelberg (DE)**
• **WULF, Jens, Wilhelm**
  **76137 Karlsruhe (DE)**
• **LEWANDOWSKI, Marek**
  **71272 Renningen (DE)**
• **HAUCK, Matthias**
  **68723 Schwetzingen (DE)**
• **EPSKAMP, Torsten**
  **75015 Bretten (DE)**
• **DOPPELBAUER, Martin**
  **75015 Bretten (DE)**
• **HARTMANN, Matthias**
  **76646 Bruchsal (DE)**

(56) Entgegenhaltungen:
**DE-A1- 19 833 953    US-A1- 2005 137 834**
**US-A1- 2008 052 059**

• **BAUSCH H ET AL: "Feed-forward control of current excited synchronous drives // Controle par avance de phase d'un entrainement synchrone alimente en courant", ICEM '94, CONFÉRENCE INTERNATIONALE SUR LES MACHINES ÉLECTRIQUES, INTERNATIONAL CONFERENCE ON ELECTRICAL MACHINES, 5 - 8 SEPTEMBRE/SEPTEMBER 1994, PALAIS DES CONGRÈS, PARIS, FRANCE, SOCIÉTÉ DES ÉLECTRICIENS ET DES ÉLECTRONICIENS, PARIS; THE INSTITUTI, Bd. 1, 5. September 1994 (1994-09-05), Seiten 220-225, XP002669654,**

**Beschreibung**

Die Erfindung betrifft ein Verfahren zum Ansteuern eines optimalen Betriebspunktes bei einer Synchronmaschine und eine umrichtergespeiste Synchronmaschine.

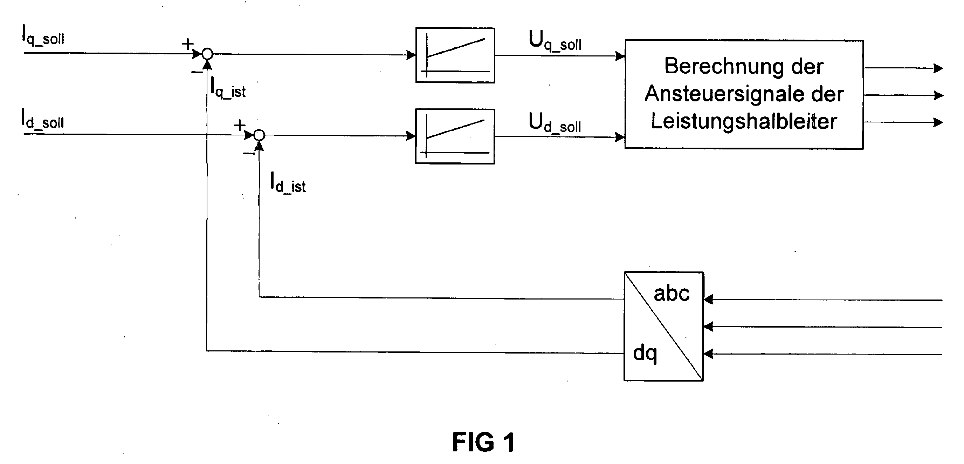

Aus der Veröffentlichung "Feed -forward control of current excited synchronous drives" von Bausch, Zeng, Kanelis aus ICEM '94, CONFERENCE INTERNATIONALE SUR LE MACHINES ELEKTRIQUES; INTERNATIONAL CONFERENCE ON ELECTRICAL MACHINES; 5-8,SEPTEMBRE/SEPTEMBER, PALAIS DES CONGRES, PARIS, FRANCE, SOCIETE DES ELECTRICIENS ET DES ELECTRONICIENS, PARIS; THE INSTITUTI, Bd. 1, 5. September 1994, Seiten 220 - 225, XP002669654, Seite 220 - Seite 221: Abbildungen 1- 5 ist ein Verfahren zur feldorientierten Regelung bekannt, bei dem Parameter eines Motors experimentell erfasst werden.

Aus der US 2008/0052059 A1 ist ein intelligentes System für die Beobachtung einer Leistungslimitierung bei einer Elektromaschine bekannt.

Aus der DE 198 33 953 A1 ist ein Verfahren zum Optimieren des Energieverbrauchs von Synchronmotoren im Teillastbereich und eine entsprechende Regelungsvorrichtung bekannt.

Aus der US 2005/0137834 A1 ist ein Verfahren zur Schätzung der Parameter eines Synchronmotors bekannt.

Der Erfindung liegt daher die Aufgabe zugrunde, eine umrichtergespeiste Synchronmaschine besser zu betreiben.

Erfindungsgemäß wird die Aufgabe bei dem Verfahren zum Ansteuern eines optimalen Betriebspunktes bei einer Synchronmaschine nach den in Anspruch 1 und bei der  umrichtergespeisten Synchronmaschine nach den in Anspruch 12 angegebenen Merkmalen gelöst.

Wichtige Merkmale der Erfindung bei dem Verfahren sind, dass es zum Ansteuern eines optimalen Betriebspunktes bei einer umrichtergespeisten Synchronmaschine vorgesehen ist, wobei

in einem ersten erfindungsgemäßen Verfahrensschritt für die Synchronmaschine mittels einer FEM-Methode oder mittels einer Messmethode eine funktionale Abhängigkeit der Spannungskomponenten $U_d$, $U_q$, $U_E$ von den Stromkomponenten $I_d$, $I_q$, $I_E$ bestimmt wird, und daraus gemäß

$$\psi_d(I_d, I_q, I_E) = \int_0^{I_d} \frac{U_d(\tilde{I}_d, I_q, I_E) - R_1 \tilde{I}_d}{d\tilde{I}_d / dt} d\tilde{I}_d + \int_0^{I_E} \frac{U_d(0, I_q, \tilde{I}_E)}{d\tilde{I}_E / dt} d\tilde{I}_E + \int_0^{I_q} \frac{U_d(0, \tilde{I}_q, 0)}{d\tilde{I}_q / dt} d\tilde{I}_q + \psi_d(0,0,0)$$

$$\psi_q(I_d, I_q, I_E) = \int_0^{I_q} \frac{U_q(I_d, \tilde{I}_q, I_E) - R_1 \tilde{I}_q}{d\tilde{I}_q / dt} d\tilde{I}_q + \int_0^{I_d} \frac{U_q(\tilde{I}_d, 0, I_E)}{d\tilde{I}_d / dt} d\tilde{I}_d + \int_0^{I_E} \frac{U_q(0, 0, \tilde{I}_E)}{d\tilde{I}_E / dt} d\tilde{I}_E + \psi_q(0,0,0) \ ,$$

$$\psi_E(I_d, I_q, I_E) = \int_0^{I_E} \frac{U_E(I_d, I_q, \tilde{I}_E) - R_2 \tilde{I}_E}{d\tilde{I}_E / dt} d\tilde{I}_E + \int_0^{I_d} \frac{U_E(\tilde{I}_d, I_q, 0)}{d\tilde{I}_d / dt} d\tilde{I}_d + \int_0^{I_q} \frac{U_E(0, \tilde{I}_q, 0)}{d\tilde{I}_q / dt} d\tilde{I}_q$$

wobei $\psi_d(0,0,0)$ die Permanentflussverkettung in einer permanenterregten Synchronmaschine beschreibt und im Falle einer fremderregten Maschine identisch 0 ist,

wobei $\tilde{I}_d$, $\tilde{I}_q$ beziehungsweise $\tilde{I}_E$ die jeweilige Integrationsvariable bezeichnet und $d\tilde{I}_d$, $d\tilde{I}_q$ beziehungsweise $d\tilde{I}_E$ das zugehörige Differential,

die jeweilige Abhängigkeit der Flussverkettungskomponenten $\psi_d$, $\psi_q$, $\psi_E$ von den Stromkomponenten $I_d$, $I_q$, $I_E$ bestimmt wird,

wobei $R_1$ und $R_2$ die ohmschen Widerstände der entsprechenden Wicklungen der Synchronmaschine sind,

in einem zweiten erfindungsgemäßen Verfahrensschritt die Synchronmaschine im geregelten Betrieb betrieben wird und dabei ein optimaler Betriebspunkt angesteuert wird,

- (1) wobei ein Erregerstromsollwert durch Lösen der nichtlinearen Optimierungsaufgabe

$$F\left(I_d, I_q, I_E\right) = \min!$$

*u.d.N.:*

$$M_{soll} = M = \frac{m}{2} p\left(\psi_d(I_d, I_q, I_E)I_q - \psi_q(I_d, I_q, I_E)I_d\right)$$

- ermittelt wird, wobei

  ○ M für das Drehmoment,
  ○ $M_{soll}$ ein gewünschtes Solldrehmoment,
  ○ m für die Strangzahl der Synchronmaschine,
  ○ p für die Polpaarzahl der Synchronmaschine
  ○ $\psi$ für den verketteten magnetischen Fluss und
  ○ F für die zu minimierende Funktion steht,

- (2) wobei der ermittelte Erregerstromsollwert als Sollwert für einen Erregerstromregler verwendet wird,
- (3) wobei ein Erregerstromistwert durch Messung oder Modellbildung ermittelt wird,
- (4) wobei unter Verwendung des ermittelten Erregerstromistwertes Statorstromsollwerte durch Lösen der nichtlineare Optimierungsaufgabe

$$F\left(I_d, I_q, I_E\right) = \min!$$

*u.d.N.:*

$$M_{soll} = M = \frac{m}{2} p\left(\psi_d(I_d, I_q, I_{E\_ist})I_q - \psi_q(I_d, I_q, I_{E\_ist})I_d\right)$$

$$I_E = I_{E\_ist}$$

- ermittelt werden, wobei

  $I_{E\_ist}$ für den Erregerstromistwert steht,

- (5) wobei die Statorstromsollwerte Statorstromreglern zugeführt werden.

Dabei wird die jeweilige Optimierungsaufgabe numerisch gelöst, also das Minimum der Funktion F bezüglich der drei Ströme gesucht. Die Werte der Ströme am Minimum werden als Sollwerte verwendet und einem Regler vorgegeben.

Die Abkürzung "u.d.N." bedeutet "unter der Nebenbedingung".

Von Vorteil ist dabei, dass ein optimaler Betriebspunkt ansteuerbar ist, zu dessen Bestimmung die Sättigungsabhängigkeiten in der Maschine vollständig beschrieben sind.

Bei einer weiteren vorteilhaften Ausgestaltung beschreibt die zu minimierende Funktion die Summe von Verlusten, insbesondere ohmsche Wärmeverluste im Motor und im Umrichter und/oder die Eisenverluste. Von Vorteil ist dabei, dass die Realisierung eines optimalen Systemwirkungsgrades besonders einfach und elegant möglich ist.

Bei einer weiteren vorteilhaften Ausführungsform wird die Spannungsgrenze berücksichtigt, indem bei den Optimierungsaufgaben die folgenden Nebenbedingungen berücksichtigt werden

$$U_d - R_1 I_d + \Omega \; \psi_q(I_d, I_q, I_E) = 0$$

$$U_q - R_1 I_q - \Omega \; \psi_d(I_d, I_q, I_E) = 0$$

$$U_{Stator\_\max}^2 \geq U_d^2 + U_q^2$$

wobei

- $\Omega$ für die elektrische Winkelgeschwindigkeit,
- $R_1$ für den ohmschen Wicklungswiderstand der Statorwicklung,
- $\psi$ für den verketteten magnetischen Fluss steht,

wobei mit der maximal zulässigen Statorspannung $U_{Stator\_max}$ die Regelreserve (Spannungsreserve) der Statorstromregler beeinflusst werden kann und diese so gewählt wird, dass die resultierende Statorstromdynamik den Anforderungen der Anwendung entspricht.

Bei einer weiteren vorteilhaften Ausführungsform wird bei den Optimierungsaufgaben die folgende Nebenbedingungen berücksichtigt

$$I_{Stator\_\max}^2 \geq I_d^2 + I_q^2$$

wobei $I_{Stator\_max}$ für den maximal zulässigen Statorstrom steht.

Bei einer weiteren vorteilhaften Ausführung wird die Größe $U_{Stator-max}$ durch einen Regler so nachgeführt, dass immer eine vorgebbare Mindestspannungsreserve der Statorstromregler gewährleistet ist.

Bei einer vorteilhaften Ausführung wird der Erregerstromsollwert so begrenzt, dass die Rotortemperatur einen vorgebbaren Grenzwert nicht überschreitet.

Bei einer weiteren vorteilhaften Ausführung wird der Erregerstromsollwert auf den Wert Null begrenzt, wenn ein Fehler, wie beispielsweise Wicklungsschluss erkannt wird.

Bei einer vorteilhaften Ausführung wird ein Erregerstromistwert ermittelt, indem dieser entweder gemessen und gefiltert wird oder über ein Modell gebildet wird.

Die Verwendung des so ermittelten Erregerstromistwertes in der Berechnung der Statorstromsollwerte hat den Vorteil, dass die Statorstromsollwerte immer passend zum zeitlichen Verlauf des Erregerstroms der Maschine gewählt werden. Insbesondere wenn die Statorstromzeitkonstante kleiner ist, als die Rotorstromzeitkonstante ermöglicht dieses Vorgehen dennoch eine hohe Drehmomentdynamik. Die vorgeschlagene Vorgehensweise zur Bestimmung der Statorstromsollwerte weist u.a. die Eigenschaft auf, dass auch die Möglichkeit der Reluktanzdrehmomentbildung implizit mit berücksichtigt wird. Damit kann die zu betreibende Synchronmaschine auch bei erkanntem Ausfall der Haupterregung (z.B. Windungsschluss der Erregerwicklung) im dann noch möglichen Rahmen optimal betrieben werden. Die Erfindung ermöglicht es zudem, dass der Erregerstromsollwert z.B. durch ein thermisches Schutzmodell begrenzt wird. Da das angeforderte Drehmoment dennoch erreicht werden soll, führt dies automatisch zu entsprechend angepassten Statorströmen. Damit verschiebt sich die Verlustleistung von der Erregerwicklung zur Statorwicklung. Häufig können diese von dort besser abgeführt werden, da diese einen kleineren thermischen Widerstand zur Umgebung bzw. Kühlsystem aufweist.

Wichtige Merkmale bei der umrichtergespeisten Synchronmaschine sind, dass in einer Signalelektronik ein Regler zur Durchführung des geregelten Betriebes angeordnet ist, wobei Stromerfassungsmittel mit dem Regler elektrisch verbunden sind und das Ausgangssignal des Reglers zum Stellen der Spannung für die Synchronmaschine vorgesehen ist, indem mittels der Signalelektronik entsprechend dem Ausgangssignal pulsweitenmodulierte Ansteuersignale steuerbaren Leistungshalbleiter eines Wechselrichters zugeführt werden, wobei der Wechselrichter die Synchronmaschine speist.

Von Vorteil ist dabei, dass die erfindungsgemäßen Verfahren in einfacher Weise durchführbar sind. Außerdem werden die Verluste des Umrichters, des Elektromotors und sogar die Verluste bei der Energieübertragung an die Erregerwicklung, insbesondere bei der transformatorischen Energieübertragung, berücksichtigt. Dabei wird aus dem Minimum der Verlustfunktion der Erregerstromsollwert bestimmt. Im transienten Zustand bis zum Erreichen des Erregerstromsollwertes werden die zum aktuellen Erregerstromistwert passenden Statorstromsollwerte wiederum aus dem Minimum der Vertustfunktion bestimmt.

Selbstverständlich ist somit auch eine Erweiterung der Verlustfunktion auf weitere verlustbehaftete Komponenten des Antriebssystems mitberücksichtigbar, indem die Funktion F entsprechend modifiziert wird. Das Prinzip der Erfindung bleibt davon unberührt.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Im Folgenden wird die Erfindung anhand von Abbildungen und eines Ausführungsbeispiel näher erläutert:

Der erfindungsgemäße Antrieb umfasst einen Synchronmotor, welcher eine Erregerfeldwicklung aufweist, beispielsweise auf seinem Rotor, durch die ein Erregerstrom $I_E$ fließt. Dabei werden die Statorwicklungen von einem Wechselrichter gespeist, dessen steuerbaren Leistungshalbleitern von einer Steuerelektronik Ansteuersignale zugeführt werden. Die Erregerfeldwicklung ist mit einer steuerbaren Spannungstelleinheit verbunden, der ebenfalls Ansteuersignale von einer Steuerelektronik zugeführt werden.

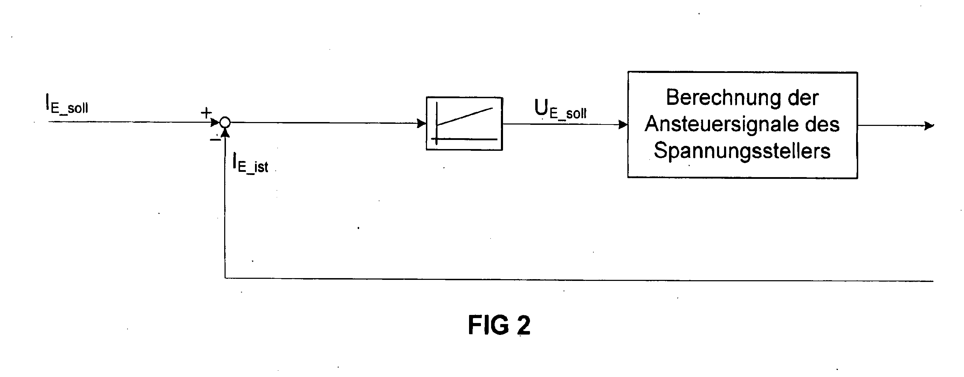

Der Erregerstrom und die Statorströme werden von Strommessgliedern erfasst und der Steuerelektronik zugeführt. Die Steuerelektronik umfasst eine Regeleinheit der Statorströme. FIG 1 zeigt das Blockschaltbild der Statorstromregeleinheit, bei der die erfassten Ströme in das übliche (d,q) Koordinatensystem, dessen Achsen also in Richtung des momentbildenden und flussorientieren Stromanteils orientiert sind, transformiert werden, von den Sollwerten abgezogen werden, Reglereinheiten die vorzugsweise einen P-Kanal und einen I-Kanal aufweisen, zugeführt werden und aus deren Ausgangsgrößen, vorzugsweise die Sollspannungen in (d,q) Koordinaten, die Ansteuersignale der Leistungshalbleiter des Wechselrichters berechnet werden. Des Weiteren umfasst die Steuerelektronik eine Regeleinheit des Erregerstromes. FIG 2 zeigt eine mögliche Erregerstrom-Reglerstruktur, bei der der ermittelte Erregerstromistwert von einem Erregerstromsollwert abgezogen wird, einer Reglereinheit, die vorzugsweise einen P-Kanal und I-Kanal aufweist, zugeführt wird und aus deren Ausgangswert, vorzugsweise die Sollspannung der Erregerfeldwicklung, Ansteuersignale für die Leistungshalbleiter einer mit der Erregerfeldwicklung verbundenen Spannungsstelleinheit berechnet werden.

In einem ersten erfindungsgemäßen Verfahrensschritt wird mittels FEM-Methode, also Finite-Elemente-Methode, der Motor modelliert. Dabei werden insbesondere die bestromten Wicklungsdrähte und die vorhandenen Materialien, wie Stahlblech oder dergleichen, mit ihren elektrischen und magnetischen Eigenschaften in einem Rechner rechentechnisch abgebildet und dann die jeweiligen Abhängigkeiten der Spannungskomponenteh $U_d$, $U_q$, $U_E$ von den Stromkomponenten $I_d$, $I_q$, $I_E$ bestimmt. Auch die ohmschen Widerstände $R_1$ der Statorwicklung und $R_2$ der Erregerwicklung der entsprechenden Wicklungen des Motors sind durch Vorausberechnungen bestimmbar.

Alternativ zur FEM-Methode sind die genannten Werte und Abhängigkeiten auch messtechnisch bestimmbar.

Mittels des Gleichungssystems

$$\psi_d(I_d, I_q, I_E) = \int_0^{I_d} \frac{U_d(\widetilde{I}_d, I_q, I_E) - R_1 \widetilde{I}_d}{d\widetilde{I}_d / dt} d\widetilde{I}_d + \int_0^{I_E} \frac{U_d(0, I_q, \widetilde{I}_E)}{d\widetilde{I}_E / dt} d\widetilde{I}_E + \int_0^{I_q} \frac{U_d(0, \widetilde{I}_q, 0)}{d\widetilde{I}_q / dt} d\widetilde{I}_q + \psi_d(0,0,0)$$

$$\psi_q(I_d, I_q, I_E) = \int_0^{I_q} \frac{U_q(I_d, \widetilde{I}_q, I_E) - R_1 \widetilde{I}_q}{d\widetilde{I}_q / dt} d\widetilde{I}_q + \int_0^{I_d} \frac{U_q(\widetilde{I}_d, 0, I_E)}{d\widetilde{I}_d / dt} d\widetilde{I}_d + \int_0^{I_E} \frac{U_q(0, 0, \widetilde{I}_E)}{d\widetilde{I}_E / dt} d\widetilde{I}_E + \psi_q(0,0,0)$$

$$\psi_E(I_d,I_q,I_E)=\int_0^{I_E}\frac{U_E(I_d,I_q,\tilde{I}_E)-R_2\tilde{I}_E}{d\tilde{I}_E\big/dt}\,d\tilde{I}_E+\int_0^{I_d}\frac{U_E(\tilde{I}_d,I_{q,0})}{d\tilde{I}_d\big/dt}\,d\tilde{I}_d+\int_0^{I_q}\frac{U_E(0,\tilde{I}_q,0)}{d\tilde{I}_q\big/dt}\,d\tilde{I}_q$$

kann schließlich die Abhängigkeit der Flüsse $\psi_d$, $\psi_q$, $\psi_E$ von den Stromkomponenten $I_d$, $I_q$, $I_E$ bestimmt werden, wobei $\psi_d(0,0,0)$ die Permanentflussverkettung in einer permanenterregten Synchronmaschine beschreibt und im Falle einer fremderregten Maschine identisch 0 ist.

Die funktionale Abhängigkeit des Drehmoments von den Strömen ergibt sich gemäß der Gleichung:

$$M=\frac{m}{2}p\big(\psi_d(I_d,I_q,I_E)I_q-\psi_q(I_d,I_q,I_E)I_d\big)$$

wobei

- p für die Polpaarzahl,
- m für die Strangzahl der Synchronmaschine,
- $\psi$ für die verketteten magnetischen Flüsse der Synchronmaschine und
- M für das Drehmoment steht.

Die funktionale Abhängigkeit der Spannung von den Strömen und der Drehzahl im stationären Betriebsfall ergibt sich aus den Gleichungen:

$$U_d=R_1 I_d-\Omega\,\psi_q(I_d,I_q,I_E)$$

$$U_q=R_1 I_q+\Omega\,\psi_d(I_d,I_q,I_E)$$

wobei

- $\Omega$ für die elektrische Winkelgeschwindigkeit der Synchronmaschine und
- $R_1$ für den ohmschen Widerstand der Statorwicklungen steht.

Des Weiteren werden Grenzwerte für den maximalen zulässigen Statorstrom ($I_{stator\_max}$) und die maximal zulässige Statorspannung ($U_{stator\_max}$) sowie ein Solldrehmoment bei einer bestimmten Drehzahl festgelegt.

In einem weiteren erfindungsgemäßen Verfahrensschritt wird ein Wert für den Erregerstromsollwert $I_E$ bestimmt, indem die nichtlineare Optimierungsaufgabe gelöst wird:

$$F\big(I_d,I_q,I_E\big)=\min!$$

unter-den-Nebenbedingungen :

$$M_{soll}=M=\frac{m}{2}p\big(\psi_d(I_d,I_q,I_E)I_q-\psi_q(I_d,I_q,I_E)I_d\big)$$

$$U_d-R_1 I_d+\Omega\,\psi_q(I_d,I_q,I_E)=0$$

$$U_q - R_1 I_q - \Omega \, \psi_d(I_d, I_q, I_E) = 0$$

$$U_{Stator\_max}^2 \geq U_d^2 + U_q^2$$

$$I_{Stator\_max}^2 \geq I_d^2 + I_q^2$$

Die zu minimierende Zielfunktion beinhaltet in einer vorteilhaften Ausführungsform die funktionale Abhängigkeit der Verlustleistung von den Strömen $I_d$, $I_q$, $I_E$, der Drehzahl und anderen Einflussfaktoren. Durch diese Vorgehensweise und der stromabhängigen Beschreibung der Flüsse $\psi_d(I_d,I_q,I_E)$, $\psi_q(I_d,I_q,I_E)$, $\psi_E(I_d,I_q,I_E)$, welche u.a. sättigungsabhängige Nichtlinearitäten impliziert, eröffnet sich die Möglichkeit, beliebige Verlustmechanismen zu berücksichtigen und schließlich zu minimieren. Es sei auch darauf hingewiesen, dass die Durchlassverluste der Leistungshalbleiter in der zu minimierenden Zielfunktion berücksichtigt werden können und damit die Systemverlustleistung minimiert werden kann.

Des Weiteren sei erwähnt, dass bei der erfindungsgemäßen Vorgehensweise prinzipiell auch die Berücksichtigung der Schaltfrequenz der Leistungshalbleiter möglich ist. Bei einer adäquaten Ausführungsform ist die Berücksichtigung von schaltfrequenzabhängigen Zusatzverlusten der Synchronmaschine obligatorisch.

Bei einer weiteren vorteilhaften Ausführungsform wird die Geräuschemission der umrichtergespeisten Synchronmaschine in der Optimierungsaufgabe berücksichtigt. Die Abhängigkeit der Geräuschemission von Drehzahl, Schaltfrequenz und Strömen kann dabei entweder durch Messung oder durch Rechnung bestimmt werden. Möglich ist eine Berücksichtigung der Geräuschemission in der Zielfunktion oder in den Nebenbedingungen der Optimierungsaufgabe.

In einem weiteren erfindungsgemäßen Verfahrensschritt wird der ermittelte Erregerstromsollwert nochmals auf einen Maximalwert begrenzt. Eine mögliche Quelle dieses zweiten Erregerstrommaximalwertes ist ein thermisches Schutzmodell, das verhindert, dass die Temperatur der Erregerfeldwicklung einen vorgebbaren Grenzwert überschreitet. Durch Reduktion des Erregerstromsollwertes werden die stromabhängigen Verluste der Erregerfeldwicklung reduziert. In dem Fall, dass die Erregerfeldwicklung auf dem Rotor der Synchronmaschine sitzt weist diese i.d.R. einen höheren thermischen Widerstand zur Umgebung bzw. zum Kühlkreislauf auf, als die Statorwicklung. Deshalb ist es sinnvoll, die Rotortemperatur durch ein Modell oder Sensorik separat zu überwachen.

In einem weiteren erfindungsgemäßen Verfahrensschritt wird dieser begrenzte Erregerstromsollwert einer Erregerstromregeleinrichtung zugeführt.

In einem weiteren erfindungsgemäßen Verfahrensschritt wird ein Erregerstromistwert gebildet, indem

- der von der Erregerstrommesseinheit gemessene Wert verwendet wird, der bei vorteilhafter Ausführungsform gefiltert wird oder
- ein von einem Modell, das bei vorteilhafter Ausführungsform die wirksame Erregerstromzeitkonstante des Erregerstromregelkreises berücksichtigt, ermittelter Wert verwendet wird oder
- der Wert Null verwendet wird, wenn eine Fehlerüberwachung die Erregerstromregeleinrichtung außer Betrieb setzen muss, da beispielsweise ein Windungsschluss in der Erregerfeldwicklung erkannt wurde oder die mit der Erregerfeldwicklung verbundene Leistungselektronik einen Fehler aufweist.

In einem weiteren erfindungsgemäßen Verfahrensschritt werden Werte für die beiden Ströme $I_d$ und $I_q$ bestimmt, indem die nichtlineare Optimierungsaufgabe

$$F\left(I_d, I_q, I_E\right) = \min!$$

*unter\_de\_Nebenbdingungen(u.d.N.)*:

$$M_{soll} = M = \frac{m}{2} p\left(\psi_d(I_d, I_q, I_{E\_ist}) I_q - \psi_q(I_d, I_q, I_{E\_ist}) I_d\right)$$

$$I_E = I_{E\_ist}$$

$$U_d - R_1 I_d + \Omega \; \psi_q(I_d, I_q, I_{E\_ist}) = 0$$

$$U_q - R_1 I_q - \Omega \; \psi_d(I_d, I_q, I_{E\_ist}) = 0$$

$$U_{Stator\_max}^2 \geq U_d^2 + U_q^2$$

$$I_{Stator\_max}^2 \geq I_d^2 + I_q^2$$

gelöst wird, bei der Erregerstrom gleich dem ermittelten Erregerstromistwert gesetzt wird.

Die ermittelten Statorstromsollwerte werden schließlich den Statorstromregeleinheiten zugeführt.

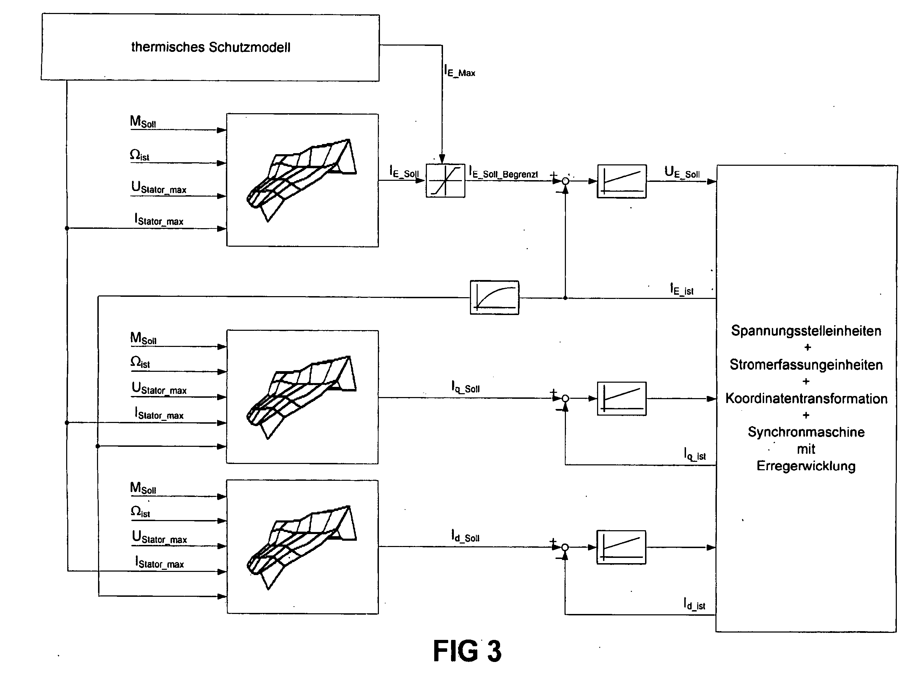

Das Blockschaltbild in FIG **3Fehler! Verweisquelle konnte nicht gefunden werden.** zeigt eine mögliche Ausführungsform, wie das erfindungsgemäße Verfahren in einem Echtzeitsystem in vorteilhafter Weise realisiert werden kann.

Dabei wird zunächst offline, also nicht im aktiven Regelbetrieb, eine mehrdimensionale Tabelle für den Erregerstromsollwert erstellt indem die nichtlineare Optimierungsaufgabe

$$F(I_d, I_q, I_E) = \min!$$

*u.d.N.*:

$$M_{soll} = M = \frac{m}{2} p(\psi_d(I_d, I_q, I_E) I_q - \psi_q(I_d, I_q, I_E) I_d)$$

$$U_d - R_1 I_d + \Omega \; \psi_q(I_d, I_q, I_E) = 0$$

$$U_q - R_1 I_q - \Omega \; \psi_d(I_d, I_q, I_E) = 0$$

$$U_{Stator\_max}^2 \geq U_d^2 + U_q^2$$

$$I_{Stator\_max}^2 \geq I_d^2 + I_q^2$$

für eine ausreichend hohe Anzahl an Drehmomentsollwerten, Drehzahlen, Statorstromgrenzwerten und Statorspannungsgrenzwerten gelöst wird. Die Quantisierung der Tabellen, also die Anzahl der in einer Eingangsdimension abzulegenden Werte, ist dabei abhängig vom maximal zulässigen Fehler und dem zur Verfügung stehenden Speicher im Echtzeitsystem. Eine allgemeingültige Empfehlung der Quantisierung ist nicht möglich.

Ebenfalls offline können die beiden Tabellen für die Statorstromsollwerte erzeugt werden, indem die nichtlineare Optimierungsaufgabe

$$F\big(I_d, I_q, I_E\big) = \min!$$

u.d.N.:

$$M_{soll} = M = \frac{m}{2}\,p\big(\psi_d(I_d, I_q, I_{E\_ist})I_q - \psi_q(I_d, I_q, I_{E\_ist})I_d\big)$$

$$I_E = I_{E\_ist}$$

$$U_d - R_1 I_d + \Omega\,\psi_q(I_d, I_q, I_{E\_ist}) = 0$$

$$U_q - R_1 I_q - \Omega\,\psi_d(I_d, I_q, I_{E\_ist}) = 0$$

$$U_{Stator\_max}^2 \geq U_d^2 + U_q^2$$

$$I_{Stator\_max}^2 \geq I_d^2 + I_q^2$$

für eine ausreichend hohe Anzahl an Erregerstromistwerten, Drehmomentsollwerten, Drehzahlen, Statorstromgrenzwerten und Statorspannungsgrenzwerten gelöst wird.

Bei einer vorteilhaften Ausführungsform erfolgt der Tabellenzugriff im Echtzeitsystem interpolierend.

Eine Variante zu Tabellen stellt eine funktionale Beschreibung der Abhängigkeit der Stromsollwerte von den Eingangsdimerisionen dar. Dies kann beispielsweise über Polynome oder andere geeignete Funktionen realisiert werden.

Im Echtzeitregelbetrieb wird der Drehmomentsollwert entweder von einem überlagerten Drehzahlregler oder im drehmomentgeregelten Betrieb direkt vom Anwender vorgegeben. Die Istdrehzahl bzw. die mechanische Kreisfrequenz wird im einfachsten Fall durch Differentiation eines Lagesignals gewonnen.

Der maximal zulässige Statorstrom wird entweder, wie im Blockschaltbild gezeigt, von einem thermischen Schutzmodell vorgegeben oder es wird der minimale Wert zwischen Schutzmodellvorgabe und parametrierten Maximalwert verwendet.

Die maximale Statorspannung ist abhängig von der maximal vom Wechselrichter stellbaren Spannung. Sollte diese nicht konstant sein, ermöglicht das im Ausführungsbeispiel illustrierte erfindungsgemäße Vorgehen deren dynamische Berücksichtigung und damit optimalen Betrieb im gesamten Drehzahlbereich ohne zwischen Feldschwächbereich und Grunddrehzahlbereich unterscheiden zu müssen. Der Vorgabeparameter $U_{Stator\_max}$ ermöglicht es zudem die Regelreserve der Statorstromregler dynamisch anzupassen was eine Anpassung der Statorstromdynamik und damit der Drehmomentdynamik bedeutet. Erwähnt sei an dieser Stelle auch, dass eine überlagerte Regeleinheit denkbar ist, welche die maximal erlaubte Statorspannung so nachführt, dass immer eine Mindestregelreserve der Statorstromregler eingehalten wird.

Im erfindungsgemäßen Ausführungsbeispiel erfolgt im nächsten Schritt der mehrdimensionale Tabellenzugriff zur Ermittlung eines Erregerstromsollwertes. Dieser wird in einem folgenden Schritt vom thermischen Schutzmodell so begrenzt, dass die Temperatur der Erregerfeldwicklung einen vorgebbaren Grenzwert nicht überschreitet. Der vom thermischen Schutzmodell begrenzte Erregerstromsollwert wird einer Erregerstromregeleinheit zugeführt.

Den Statorstromsollwerttabellen wird im Ausführungsbeispiel neben dem Drehmomentsollwert, der elektrischen Kreisfrequenz, der maximalen Statorspannung und des maximalen Statorstroms ein von einer Strommesseinheit erfasster und gefilterter Erregerstromistwert zugeführt. Die durch Tabellenzugriff ermittelten Sollwerte $I_{d\_soll}$ und $I_{q\_soll}$ werden den Statorstromregeleinheiten zugeführt.

Das im Ausführungsbeispiel illustrierte, erfindungsgemäße Vorgehen weist u.a. den Vorteil auf, dass die Verluste auf elegante Art von der Erregerfeldwicklung auf die Statorwicklung verschoben werden können indem der Erregerstromsollwert begrenzt wird. Wenn die Erregerfeldwicklung auf dem Rotor sitzt und somit einen höheren thermischen Widerstand zur Umgebung bzw. zum Kühlkreislauf aufweist, kann diese dem erfindungsgemäßen Verfahren inhärente Eigenschaft von großem Nutzen sein, da hohe Überlastfähigkeit u.a. mit hohem Wirkungsgrad möglich ist. Erst mit der i.d.R. sehr großen thermischen Zeitkonstanten verschieben sich die Verluste von der Erregerfeldwicklung auf die Statorwicklung und es reduziert sich somit zunächst der Gesamtwirkungsgrad bis auch die thermische Gesamtgrenze erreicht ist und der Statorstrom ebenfalls reduziert werden muss. In diesem Fall sind allerdings die physikalischen Grenzen des Systems erreicht.

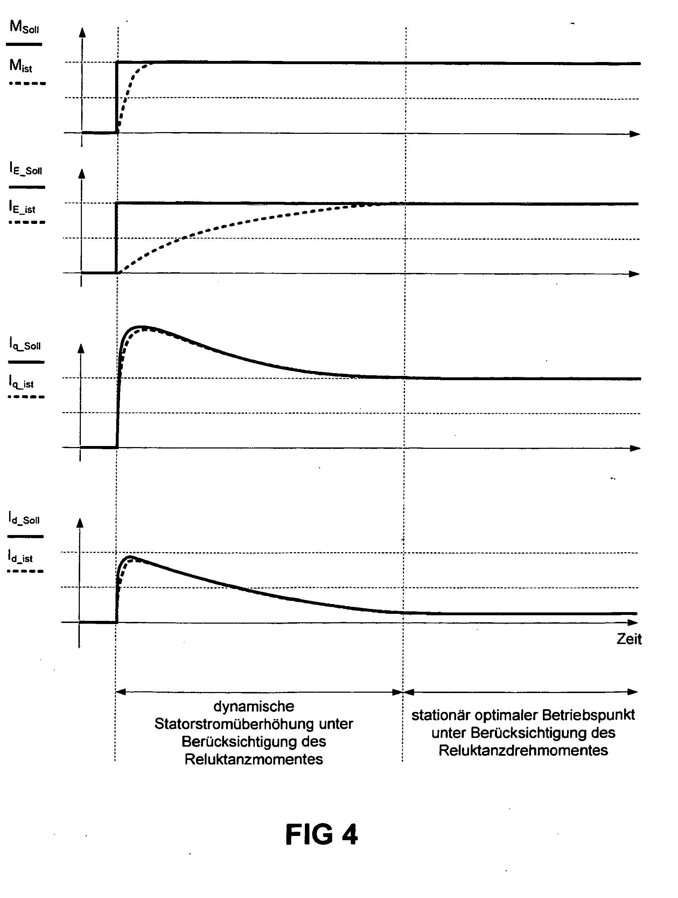

Ein weiterer Vorteil des erfindungsgemäßen Verfahrens soll im Folgenden anhand der in FIG 4 dargestellten Strom und Drehmomentverläufe erläutert werden.

Wird von einem übergeordneten System ein Drehmomentsprung angefordert, was der durchgezogenen Linie im ersten Diagramm entspricht, wird vom erfindungsgemäßen Verfahren sofort ein entsprechender Erregerstromsollwert ermittelt, welcher der durchgezogenen Linie im zweiten Diagramm entspricht. Die resultierende Zeitkonstante des Erregerstroms ist i.d.R. sehr viel größer als die Statorstromzeitkonstante. Der Erregerstromistwert ist ebenfalls im zweiten Diagramm mit der gestrichelten Linie eingezeichnet. Dieser Istwert wird bei der Ermittlung der Statorströme verwendet. Es ist nachvollziehbar, dass beim Aufschalten des Drehmomentsollwertes noch keine Erregung vorhanden ist und die Statorstromsollwerte so gewählt werden müssen, dass eine Drehmomentbildung über das Reluktanzprinzip erfolgt. Das erfindungsgemäße Verfahren weist die Eigenschaft auf, genau dies zu ermöglichen. Die ermittelten Statorstromsollwerte berücksichtigen in idealer Weise die aktuelle Erregung. In Diagramm drei und vier sind die Sollwertverläufe mit den durchgezogenen Linien dargestellt. Diese weisen eine deutliche Überhöhung im Vergleich mit den stationären optimalen Betriebspunkten auf. Die gestrichelten Linien in Diagramm drei und vier zeigen die Verläufe der Statorstromistwerte, welche aufgrund der i.d.R. kleinen Statorstromzeitkonstanten quasi identisch mit den Sollwertverläufen sind. Im ebenfalls gestrichelt eingezeichneten Drehmomentistwertverlauf in Diagramm eins ist deutlich zu erkennen, dass aufgrund des erfindungsgemäßen Verfahrens trotz einer großen Erregerstromzeitkonstanten eine hohe Drehmomentdynamik bei stationär optimalem Systemwirkungsgrad möglich ist.

Des Weiteren machen die Strom- und Drehmomentverläufe in FIG 4 transparent, dass die Statorstromsollwerte vom erfindungsgemäßen Verfahren immer so gewählt werden, dass sich für den aktuellen Erregerstromistwert das gewünschte Solldrehmoment einstellt. Bei Ausfall der Erregung bedeutet dies, wenn ein Erregerstromistwert von Null rückgeführt wird, dass die Synchronmaschine weiterhin, im dann noch möglichen Rahmen, optimal betrieben werden kann, da das erfindungsgemäße Verfahren dann automatisch Statorstromsollwerte generiert die optimalen Reluktanzbetrieb ermöglichen.

In einem konkreten Ausführungsbeispiel ist die genannte Funktion F folgendermaßen definiert.

$$F\left(I_d, I_q, I_E\right) = V_{Cu1}\left(I_d, I_q\right) + V_{Cu2}\left(I_E\right) + V_{Fe}\left(I_d, I_q, I_E\right) + V_{Mag}\left(I_d, I_q, I_E\right) + V_{Umrichter}\left(I_d, I_q, I_E\right) + V_{Trafo}\left(I_d, I_q, I_E\right),$$

wobei

$$V_{Cu1}\left(I_d, I_q\right) = \left(I_d^2 + I_q^2\right)R_1,$$

wobei

$$V_{Cu2}\left(I_E\right) = I_E^2 R_2,$$

wobei

$$V_{Fe}\left(I_d, I_q, I_E\right) = V_{Fe1}\left(I_d, I_q, I_E\right) + V_{Fe2}\left(I_d, I_q, I_E\right),$$

*wobei*

$$V_{Fe1}\left(I_d,I_q,I_E\right)=p_{1,Fe1}n^{3/2}\left(\psi_d\left(I_d,I_q,I_E\right)^2+\psi_q\left(I_d,I_q,I_E\right)^2\right)+p_{2,Fe1}n+p_{3,Fe1}n^2,$$

*wobei*

$$V_{Fe2}\left(I_d,I_q,I_E\right)=p_{1,Fe2}n^{3/2}\left(\left(\psi_d\left(I_d,I_q,I_E\right)-\psi_{PM}\right)^2+\psi_q\left(I_d,I_q,I_E\right)^2\right)$$

*wobei*

$$V_{Mag}\left(I_d,I_q\right)=p_{1,Mag}n^{3/2}\left(\left(\psi_d\left(I_d,I_q,I_E\right)-\psi_{PM}\right)^2+\psi_q\left(I_d,I_q,I_E\right)^2\right)$$

*wobei*

$$V_{Umrichter}\left(I_d,I_q\right)=p_{1,Umrichter}\left(\sqrt{I_d^2+I_q^2}\right)+p_{2,Umrichter}\left(I_d^2+I_q^2\right),$$

*wobei*

$$V_{Trafo}\left(I_E\right)=p_{1,Trafo}I_E^2,$$

wobei $n$         Motordrehzahl,

wobei $R_1$         Statorwiderstand,

wobei $R_2$         Rotorwiderstand,

wobei $\psi_d$         Statorflussverkettung in d-Achsenrichtung

wobei $\psi_q$         Statorflussverkettung in q-Achsenrichtung

wobei $\psi_{PM}=\psi_d(I_d{=}0,\,I_q=0)$         Permanentmagnetflussverkettung, insbesondere bei permanenterregter Synchronmaschine,

wobei $V_{Cu1}(I_d,I_q)$         Statorstromwärmeverluste,

wobei $V_{Cu2}(I_E)$         Rotorstromwärmeverluste,

wobei $V_{Fe1}(I_d,I_q,I_E)$         Statoreisenverluste,

wobei $p_{1,Fe1},p_{2,Fe1},p_{3,Fe1}$         Parameter zur Beschreibung der Eisenverluste im Stator, zu erhalten aus Messung oder FEM-Berechnung,

wobei $V_{Fe2}(I_d,I_q,I_E)$         Rotoreisenverluste,

wobei $P_{1,Fe2}$         Parameter zur Beschreibung der Eisenverluste im Rotor, zu erhalten aus Messung oder FEM-Berechnung,

| | |
|---|---|
| wobei $V_{Mag}(I_d, I_q)$ | Magnetverluste, |
| wobei $p_{1,mag}$ | Parameter zur Beschreibung der Magnetverluste, die bestimmt werden aus Messung oder FEM-Berechnung, |
| wobei $V_{Umrichter}(I_d, I_q)$ | Umrichterverluste, |
| wobei $p_{1,Umrichter}$ | Parameter zur Beschreibung des linearen Anteils der Umrichterverluste (Schalt- und Durchlassverluste), die bestimmt werden aus Bauteildaten, |
| wobei $p_{2,Umrichter}$ | Parameter zur Beschreibung des quadratischen Anteils der Umrichterverluste, insbesondere nur Durchlassverluste, die bestimmt werden aus Bauteildaten, |
| wobei $V_{Trafo}(I_E)$ | Transformatorverluste, also Verluste bei der transformatorischen Versorgung der Erregerwicklung, |
| wobei $p_{1,Trafo}$ | Parameter zur Beschreibung der Übertragerverluste bei der fremderregten Synchronmaschine bedeuten, die messtechnisch oder mit einem numerischen Modell bestimmt werden. |

Zur Bestimmung der genannten Parameter werden diese numerisch derart gewählt, dass im Arbeitsbereich der Maschine zwischen einer jeweiligen Verlustfunktion und einer entsprechenden gemessenen oder mittels FEM-Simulation bestimmten Messkurve eine möglichst kleine Abweichung erreicht wird.

Bei anderen Ausführungsbeispielen wird je nach verwendeter Maschine der jeweilige Verlusttyp weggelassen oder hinzugefügt. So hat beispielsweise die fremderregte Maschine keine Magnetverluste, während die Permanenterregte Maschine keine Übertragerverluste hat.

Bei anderen Ausführungsbeispielen werden im Falle einer offline-Bestimmung die Statorstromsollwerte auf einem diskreten Gitter für alle potentiellen Erregerstromistwerte bestimmt.

**Patentansprüche**

1. Verfahren zum Ansteuern eines optimalen Betriebspunktes bei einer Synchronmaschine, insbesondere im quasistationären Betrieb,
   **dadurch gekennzeichnet, dass**
   in einem ersten erfindungsgemäßen Verfahrensschritt für die Synchronmaschine mittels einer FEM-Methode oder mittels einer Messmethode eine funktionale Abhängigkeit der Spannungskomponenten $U_d$, $U_q$, $U_E$ von den Stromkomponenten $I_d$, $I_q$, $I_E$ bestimmt wird,
   und daraus gemäß

$$\psi_d(I_d, I_q, I_E) = \int_0^{I_d} \frac{U_d(\tilde{I}_d, I_q, I_E) - R_1\tilde{I}_d}{d\tilde{I}_d / dt} d\tilde{I}_d + \int_0^{I_E} \frac{U_d(0, I_q, \tilde{I}_E)}{d\tilde{I}_E / dt} d\tilde{I}_E + \int_0^{I_q} \frac{U_d(0, \tilde{I}_q, 0)}{d\tilde{I}_q / dt} d\tilde{I}_q + \psi_d(0,0,0)$$

$$\psi_q(I_d, I_q, I_E) = \int_0^{I_q} \frac{U_q(I_d, \tilde{I}_q, I_E) - R_1\tilde{I}_q}{d\tilde{I}_q / dt} d\tilde{I}_q + \int_0^{I_d} \frac{U_q(\tilde{I}_d, 0, I_E)}{d\tilde{I}_d / dt} d\tilde{I}_d + \int_0^{I_E} \frac{U_q(0, 0, \tilde{I}_E)}{d\tilde{I}_E / dt} d\tilde{I}_E + \psi_q(0,0,0)$$

$$\psi_E(I_d, I_q, I_E) = \int_0^{I_E} \frac{U_E(I_d, I_q, \tilde{I}_E) - R_2\tilde{I}_E}{d\tilde{I}_E / dt} d\tilde{I}_E + \int_0^{I_d} \frac{U_E(\tilde{I}_d, I_{q,0})}{d\tilde{I}_d / dt} d\tilde{I}_d + \int_0^{I_q} \frac{U_E(0, \tilde{I}_q, 0)}{d\tilde{I}_q / dt} d\tilde{I}_q$$

die jeweilige Abhängigkeit der Flussverkettungskomponente $\psi_d$, $\psi_q$, $\psi_E$ von den Stromkomponenten $I_d$, $I_q$, $I_E$ bestimmt wird,

wobei $R_1$ und $R_2$ die ohmschen Widerstände der entsprechenden Wicklungen der Synchronmaschine sind, in einem zweiten erfindungsgemäßen Verfahrensschritt die Synchronmaschine im geregelten Betrieb betrieben wird und dabei ein optimaler Betriebspunkt angesteuert wird,

- wobei ein Erregerstromsollwert durch Lösen der nichtlinearen Optimierungsaufgabe

$$F\left(I_d, I_q, I_E\right) = \min!$$

u.d.N.:

$$M_{soll} = M = \frac{m}{2} p\left(\psi_d(I_d, I_q, I_E)I_q - \psi_q(I_d, I_q, I_E)I_d\right)$$

- ermittelt wird, wobei

M für das Drehmoment,
$M_{soll}$ ein gewünschtes Solldrehmoment,
m für die Strangzahl der Synchronmaschine,
p für die Polpaarzahl der Synchronmaschine
$\psi$ für den verketteten magnetischen Fluss und
F für die zu minimierende Funktion steht,
insbesondere wobei der Wert der Variablen $I_E$ am bestimmten Minimum der Funktion F als Erregerstromsollwert verwendet wird,

- wobei der ermittelte Erregerstromsollwert als Sollwert für einen Erregerstromregler verwendet wird,
- wobei ein Erregerstromistwert durch Messung oder Modellbildung ermittelt wird,
- wobei unter Verwendung des ermittelten Erregerstromistwertes Statorstromsollwerte durch Lösen der nichtlineare Optimierungsaufgabe

$$F\left(I_d, I_q, I_E\right) = \min!$$

u.d.N. :

$$M_{soll} = M = \frac{m}{2} p\left(\psi_d(I_d, I_q, I_{E\_ist})I_q - \psi_q(I_d, I_q, I_{E\_ist})I_d\right)$$

$$I_E = I_{E\_ist}$$

- ermittelt werden, wobei

$I_{E\_ist}$ für den Erregerstromistwert steht,
insbesondere wobei die Werte der Variablen $I_d$ und $I_q$ am bestimmten Minimum der Funktion F als die Statorstromsollwerte, insbesondere als jeweilige entsprechende Statorstromsollwerte, verwendet werden,

- wobei die Statorstromsollwerte entsprechenden Statorstromreglern zugeführt werden, insbesondere also einem Stromregler für $I_d$ und einem Stromregler für $I_q$, insbesondere wobei diesen beiden Stromreglern jeweilige Istwerte zugeführt werden, die aus dem erfassten Istwert des Motorstroms, insbesondere also des Motorstromraumzeigers, bestimmt werden,

wobei die zu minimierende Funktion F die Summe von Verlusten, insbesondere ohmsche Stromwärmeverluste und/ oder Eisenverluste, beschreibt, insbesondere in Abhängigkeit der Ströme $I_d$, $I_q$, $I_E$, insbesondere wobei die zu minimierende Funktion F als Summe aus den zur Synchronmaschine, insbesondere umrichtergespeisten Synchronmaschine, gehörigen Einzelverlusten gebildet ist, insbesondere als Summe aus Modellwerten für Statorstromwärmeverluste, Rotorstromwärmeverluste, Statoreisenverluste, Rotoreisenverluste, Umrichterverluste und/oder Transformatorverluste bei der transformatorischen Versorgung der Erregerwicklung oder Schleifkontaktverluste bei der Schleifkontaktversorgung der Erregerwicklung gebildet wird.

2. Verfahren nach mindestens einem der vorangegangenen Ansprüche,
   **dadurch gekennzeichnet, dass**
   die Optimierungsaufgabe der Minimumbestimmung der Funktion F numerisch gelöst wird, wobei als Lösung jedem der Ströme $I_d, I_q, I_E$ *ein* Wert zugeordnet ist und der dem Strom $I_E$ zugeordnete Wert als Erregerstromsollwert verwendet wird.

3. Verfahren nach mindestens einem der vorangegangenen Ansprüche,
   **dadurch gekennzeichnet, dass**
   bei den Optimierungsaufgaben die folgenden Nebenbedingungen berücksichtigt werden

$$U_d - R_1 I_d + \Omega\ \psi_q(I_d, I_q, I_E) = 0$$

$$U_q - R_1 I_q - \Omega\ \psi_d(I_d, I_q, I_E) = 0$$

$$U_{Stator\_max}^2 \geq U_d^2 + U_q^2$$

wobei

- $\Omega$ für die elektrische Winkelgeschwindigkeit,
- $R_1$ für den ohmschen Wicklungswiderstand der Statorwicklung,
- $\psi$ für den verketteten magnetischen Fluss steht und
- $U_{Stator\_max}$ für die maximal zulässige Statorspannung steht.

4. Verfahren nach mindestens einem der vorangegangenen Ansprüche,
   **dadurch gekennzeichnet, dass**
   bei den Optimierungsaufgaben die folgende Nebenbedingung berücksichtigt wird

$$I_{Stator\_max}^2 \geq I_d^2 + I_q^2$$

wobei $I_{Stator\_max}$ für den maximal zulässigen Statorstrom steht.

5. Verfahren nach mindestens einem der vorangegangenen Ansprüche,
   **dadurch gekennzeichnet, dass**
   die maximale Statorspannung $U_{Stator\_max}$ von einem überlagerten Regelsystem so vorgegeben wird, dass eine Mindestregelreserve der Statorstromregler eingehalten wird.

6. Verfahren nach mindestens einem der vorangegangenen Ansprüche,
   **dadurch gekennzeichnet, dass**

der ermittelte Erregerstromsollwert auf einen Maximalwert begrenzt wird.

7. Verfahren nach mindestens einem der vorangegangenen Ansprüche,
   **dadurch gekennzeichnet, dass**
   die Begrenzung des Erregerstromsollwertes durch ein thermische Schutzmodell durchgeführt wird.

8. Verfahren nach mindestens einem der vorangegangenen Ansprüche,
   **dadurch gekennzeichnet, dass**
   die Lösung der nichtlinearen Optimierungsaufgaben offline, also nicht im geregelten Betrieb für mehrere Punkte durchgeführt wird und im geregelten Betrieb die Ergebnisse in Form von Tabellen oder funktionalen Beschreibungsformen verwendet werden.

9. Verfahren nach mindestens einem der vorangegangenen Ansprüche,
   **dadurch gekennzeichnet, dass**
   ein Erregerstromistwert durch Messung oder Modellbildung ermittelt wird.

10. Verfahren nach mindestens einem der vorangegangenen Ansprüche,
    **dadurch gekennzeichnet, dass**
    bei erkennbarem Ausfall der Erregung der rückgeführte Erregerstromistwert auf den Wert Null gesetzt wird.

11. Verfahren nach mindestens einem der vorangegangenen Ansprüche,
    **dadurch gekennzeichnet, dass**
    bei Synchronmaschinen ohne Erregerfeldwicklung der Erregerstrom- Sollwert- bzw. Istwert nicht existiert und eine Ermittlung eines Erregerstromsoll- bzw. istwertes entfällt.

12. Umrichtergespeiste Synchronmaschine,
    wobei in einer Signalelektronik ein Regler zur Durchführung des geregelten Betriebes angeordnet ist,
    wobei Stromerfassungsmittel mit dem Regler elektrisch verbunden sind und das Ausgangssignal des Reglers zum Stellen der Spannung für die Synchronmaschine vorgesehen ist,
    indem mittels der Signalelektronik entsprechend dem Ausgangssignal pulsweitenmodulierte Ansteuersignale steuerbaren Leistungshalbleiter eines Wechselrichters zugeführt werden,
    wobei der Wechselrichter die Synchronmaschine speist,
    wobei ein die Signalelektronik einen optimalen Betriebspunkt bei einer Synchronmaschine, insbesondere im quasistationären Betrieb, ansteuert,
    wobei
    ein Mittel zur Bestimmung einer funktionalen Abhängigkeit der Spannungskomponenten $U_d$, Uq, $U_E$ von den Stromkomponenten $I_d$, $I_q$, $I_E$ für die Synchronmaschine mittels einer FEM-Methode oder mittels einer Messmethode, wobei daraus gemäß

$$\psi_d(I_d,I_q,I_E) = \int_0^{I_d} \frac{U_d(\tilde{I}_d,I_q,I_E) - R_1\tilde{I}_d}{d\tilde{I}_d/dt} d\tilde{I}_d + \int_0^{I_E} \frac{U_d(0,I_q,\tilde{I}_E)}{d\tilde{I}_E/dt} d\tilde{I}_E + \int_0^{I_q} \frac{U_d(0,\tilde{I}_q,0)}{d\tilde{I}_q/dt} d\tilde{I}_q + \psi_d(0,0,0)$$

$$\psi_q(I_d,I_q,I_E) = \int_0^{I_q} \frac{U_q(I_d,\tilde{I}_q,I_E) - R_1\tilde{I}_q}{d\tilde{I}_q/dt} d\tilde{I}_q + \int_0^{I_d} \frac{U_q(\tilde{I}_d,0,I_E)}{d\tilde{I}_d/dt} d\tilde{I}_d + \int_0^{I_E} \frac{U_q(0,0,\tilde{I}_E)}{d\tilde{I}_E/dt} d\tilde{I}_E + \psi_q(0,0,0)$$

$$\psi_E(I_d,I_q,I_E) = \int_0^{I_E} \frac{U_E(I_d,I_q,\tilde{I}_E) - R_2\tilde{I}_E}{d\tilde{I}_E/dt} d\tilde{I}_E + \int_0^{I_d} \frac{U_E(\tilde{I}_d,I_{q,0})}{d\tilde{I}_d/dt} d\tilde{I}_d + \int_0^{I_q} \frac{U_E(0,\tilde{I}_q,0)}{d\tilde{I}_q/dt} d\tilde{I}_q$$

die jeweilige Abhängigkeit der Flussverkettungskomponente $\psi_d$, $\psi_q$, $\psi_E$ von den Stromkomponenten $I_d$, $I_q$, $I_E$ bestimmt wird,
wobei $R_1$ und $R_2$ die ohmschen Widerstände der entsprechenden Wicklungen der Synchronmaschine sind,
wobei die Signalelektronik die Synchronmaschine im geregelten Betrieb betreibt und dabei einen optimalen Betriebspunkt ansteuert,

- wobei ein Erregerstromsollwert durch Lösen der nichtlinearen Optimierungsaufgabe

$$F\!\left(I_d, I_q, I_E\right) = \min!$$

$u.d.N.:$

$$M_{soll} = M = \frac{m}{2} p\!\left(\psi_d(I_d, I_q, I_E) I_q - \psi_q(I_d, I_q, I_E) I_d\right)$$

- ermittelt wird, wobei

M für das Drehmoment, $M_{soll}$ ein gewünschtes Solldrehmoment, m für die Strangzahl der Synchronmaschine, p für die Polpaarzahl der Synchronmaschine $\psi$ für den verketteten magnetischen Fluss und F für die zu minimierende Funktion steht,
insbesondere wobei der Wert der Variablen $I_E$ am bestimmten Minimum der Funktion F als Erregerstromsollwert verwendet wird,

- wobei der ermittelte Erregerstromsollwert als Sollwert für einen Erregerstromregler verwendet wird,
- wobei ein Erregerstromistwert durch Messung oder Modellbildung ermittelt wird,
- wobei unter Verwendung des ermittelten Erregerstromistwertes Statorstromsollwerte durch Lösen der nichtlineare Optimierungsaufgabe

$$F\!\left(I_d, I_q, I_E\right) = \min!$$

$u.d.N.:$

$$M_{soll} = M = \frac{m}{2} p\!\left(\psi_d(I_d, I_q, I_{E\_ist}) I_q - \psi_q(I_d, I_q, I_{E\_ist}) I_d\right)$$

$$I_E = I_{E\_ist}$$

- ermittelt werden, wobei

$I_{E\_ist}$ für den Erregerstromistwert steht,
insbesondere wobei die Werte der Variablen $I_d$ und $I_q$ am bestimmten Minimum der Funktion F als die Statorstromsollwerte, insbesondere als jeweilige entsprechende Statorstromsollwerte, verwendet werden,

- wobei die Statorstromsollwerte entsprechenden Statorstromreglern zugeführt werden, insbesondere also einem Stromregler für $I_d$ und einem Stromregler für $I_q$, insbesondere wobei diesen beiden Stromreglern jeweilige Istwerte zugeführt werden, die aus dem erfassten Istwert des Motorstroms, insbesondere also des Motorstromraumzeigers, bestimmt werden,

wobei die zu minimierende Funktion F die Summe von Verlusten, insbesondere ohmsche Stromwärmeverluste und/ oder Eisenverluste, beschreibt, insbesondere in Abhängigkeit der Ströme $I_d$, $I_q$, $I_E$,

insbesondere wobei die zu minimierende Funktion F als Summe aus den zur Synchronmaschine, insbesondere umrichtergespeisten Synchronmaschine, gehörigen Einzelverlusten gebildet ist,

insbesondere als Summe aus Modellwerten für Statorstromwärmeverluste, Rotorstromwärmeverluste, Statoreisenverluste, Rotoreisenverluste, Umrichterverluste und/oder Transformatorverluste bei der transformatorischen Versorgung der Erregerwicklung oder Schleifkontaktverluste bei der Schleifkontaktversorgung der Erregerwicklung gebildet wird.

## Claims

1. Method for setting an optimal operating point in a synchronous machine, in particular in quasi-steady-state operation, **characterised in that**

in a first method step according to the invention a functional dependence of the voltage components $U_d$, Uq, $U_E$ on the current components $I_d$, $I_q$, $I_E$ is determined for the synchronous machine by means of an FEM method or by means of a measurement method,

and the respective dependence of the flux linkage component $\psi_d$, $\psi_q$, $\psi_E$ on the current components $I_d$, $I_q$, $I_E$ is determined from this according to

$$\psi_d\left(I_d, I_q, I_E\right) = \int_0^{I_d} \frac{U_d(\tilde{I}_d, I_q, I_E) - R_1\tilde{I}_d}{d\tilde{I}_d/dt} d\tilde{I}_d + \int_0^{I_E} \frac{U_d(0, I_q, \tilde{I}_E)}{d\tilde{I}_E/dt} d\tilde{I}_E + \int_0^{I_q} \frac{U_d(0, \tilde{I}_q, 0)}{d\tilde{I}_q/dt} d\tilde{I}_q + \psi_d(0,0,0)$$

$$\psi_d\left(I_d, I_q, I_E\right) = \int_0^{I_q} \frac{U_q(I_d, \tilde{I}_q, I_E) - R_1\tilde{I}_q}{d\tilde{I}_q/dt} d\tilde{I}_q + \int_0^{I_d} \frac{U_q(\tilde{I}_d, 0, I_E)}{d\tilde{I}_d/dt} d\tilde{I}_d + \int_0^{I_E} \frac{U_q(0, 0, \tilde{I}_E)}{d\tilde{I}_E/dt} d\tilde{I}_E + \psi_q(0,0,0)$$

$$\psi_E\left(I_d, I_q, I_E\right) = \int_0^{I_E} \frac{U_E(I_d, I_q, \tilde{I}_E) - R_2\tilde{I}_E}{d\tilde{I}_E/dt} d\tilde{I}_E + \int_0^{I_d} \frac{U_E(\tilde{I}_d, I_{q,0})}{d\tilde{I}_d/dt} d\tilde{I}_d + \int_0^{I_q} \frac{U_E(0, \tilde{I}_q, 0)}{d\tilde{I}_q/dt} d\tilde{I}_q$$

where $R_1$ and $R_2$ are the ohmic resistances of the corresponding windings of the synchronous machine, in a second method step according to the invention the synchronous machine is operated in regulated operation and in so doing an optimal operating point is set,

- wherein a target value of the exciting current is ascertained by solving the nonlinear optimisation problem

$$F(I_d, I_q, I_E) = \min!$$

under the *constraint:*

$$M_{target} = M = \frac{m}{2}p\left(\psi_d(I_d, I_q, I_E) I_q - \psi_q(I_d, I_q, I_E) I_d\right),$$

where

M stands for the torque,
$M_{target}$ stands for a desired target value torque,
m stands for the number of phases of the
synchronous machine,
p stands for the number of pole pairs of the
synchronous machine
$\psi$ stands for the linked magnetic flux and
F stands for the function to be minimised,
in particular where the value of the variable $I_E$ at the particular minimum of the function F is used as
target value of the exciting current,

- wherein the ascertained target value of the exciting current is used as target value for an exciting current
regulator,
- wherein an instantaneous value of the exciting current is ascertained by measurement or modelling,
- wherein target values of the stator current are ascertained using the ascertained instantaneous value of
the exciting current by solving the nonlinear optimisation problem

$$F(I_d, I_q, I_E) = \min!$$

*under the constraints:*

$$M_{target} = M = \frac{m}{2}p(\psi_d(I_d, I_q, I_{E\_inst}) I_q - \psi_q(I_d, I_q, I_{E\_inst}) I_d)$$

$$I_E = I_{E\_inst},$$

where

$I_{E\_inst}$ represents the instantaneous value of the exciting current,
in particular where the values of the variables $I_d$ and $I_q$ at the particular minimum of the function *F* are
used as target values of the stator current, in particular as respective corresponding target values of
the stator current,

- wherein the target values of the stator current are supplied to corresponding stator current regulators, in
particular therefore to a current regulator for $I_d$ and a current regulator for $I_q$,
in particular wherein respective instantaneous values are supplied to these two current regulators, which
values are determined from the detected instantaneous value of the motor current, in particular therefore
of the motor current space phasor,

wherein the function F to be minimised describes the sum of losses, in particular ohmic losses and/or iron losses,
in particular in dependence on the currents $I_d$, $I_q$, $I_E$,
in particular wherein the function F to be minimised is formed as the sum of the individual losses associated with
the synchronous machine, in particular converter-fed synchronous machine,
in particular is formed as the sum of model values for stator ohmic losses, rotor ohmic losses, stator iron losses,
rotor iron losses, converter losses and/or transformer losses on supply of the exciting winding by transformer or
sliding contact losses on supply of the exciting winding by sliding contact.

2. Method according to at least one of the preceding claims,
**characterised in that**
the optimisation problem of determining the minimum of the function F is solved numerically, wherein as solution a value is assigned to each of the currents $I_d$, $I_q$, $I_E$ and the value assigned to the current $I_E$ is used as target value of the exciting current.

3. Method according to at least one of the preceding claims,
**characterised in that**
in the optimisation problems the following constraints are taken into account

$$U_d \ - \ R_1 I_d \ + \ \Omega \psi_q (I_d, I_q, I_E) \ = \ 0$$

$$U_q \ - \ R_1 I_q \ - \ \Omega \psi_d (I_d, I_q, I_E) \ = \ 0$$

$$U_{stator\_max}^2 \geq U_d^2 + U_q^2$$

where

  - $\Omega$ stands for the electrical angular velocity,
  - $R_1$ stands for the ohmic winding resistance of the stator winding,
  - $\psi$ stands for the linked magnetic flux and
  - $U_{stator\_max}$ stands for the maximum permissible stator voltage.

4. Method according to at least one of the preceding claims,
**characterised in that**
in the optimisation problems the following constraint is taken into account

$$I_{stator\_max}^2 \geq U_d^2 + U_q^2$$

where $I_{stator\_max}$ stands for the maximum permissible stator current.

5. Method according to at least one of the preceding claims,
**characterised in that**
the maximum stator voltage $U_{stator\_max}$ is predetermined by a higher-level regulating system such that a minimum regulating reserve of the stator current regulator is maintained.

6. Method according to at least one of the preceding claims,
**characterised in that**
the ascertained target value of the exciting current is limited to a maximum value.

7. Method according to at least one of the preceding claims,
**characterised in that**
the limitation of the target value of the exciting current is carried out by a thermal protection model.

8. Method according to at least one of the preceding claims,
**characterised in that**
the solution of the nonlinear optimisation problems is carried out offline, i.e. not in regulated operation for a plurality of points, and in regulated operation the results are used in the form of tables or functional description forms.

9. Method according to at least one of the preceding claims,
**characterised in that**
an instantaneous value of the exciting current is ascertained by measurement or modelling.

**10.** Method according to at least one of the preceding claims,
**characterised in that**
in the event of detectable failure of the excitation, the fedback instantaneous value of the exciting current is set to the value of zero.

**11.** Method according to at least one of the preceding claims,
**characterised in that**
in synchronous machines without exciting field winding, the target value and instantaneous value of the exciting current do not exist and ascertainment of a target value and an instantaneous value is no longer required.

**12.** Converter-fed synchronous machine,
wherein a regulator for carrying out the regulated operation is arranged in signal electronics,
wherein current detection means are electrically connected to the regulator and the output signal of the regulator is provided for controlling the voltage for the synchronous machine
by supplying pulse-width-modulated drive signals to controllable power semiconductors of an inverter by means of the signal electronics according to the output signal,
wherein the inverter feeds the synchronous machine,
wherein the signal electronics set an optimal operating point in a synchronous machine, in particular in quasi-steady-state operation,
wherein
a means for determining a functional dependence of the voltage components $U_d$, Uq, $U_E$ on the current components $I_d$, Iq, $I_E$ for the synchronous machine by means of an FEM method or by means of a measurement method,
wherein the respective dependence of the flux linkage component $\psi_d$, $\psi_q$, $\psi_E$ on the current components $I_d$, $I_q$, $I_E$ is determined from this according to

$$\psi_d(I_d, I_q, I_E) = \int_0^{I_d} \frac{U_d(\tilde{I}_d, I_q, I_E) - R_1\tilde{I}_d}{d\tilde{I}_d/dt} d\tilde{I}_d + \int_0^{I_E} \frac{U_d(0, I_q, \tilde{I}_E)}{d\tilde{I}_E/dt} d\tilde{I}_E + \int_0^{I_q} \frac{U_d(0, \tilde{I}_q, 0)}{d\tilde{I}_q/dt} d\tilde{I}_q + \psi_d(0,0,0)$$

$$\psi_d(I_d, I_q, I_E) = \int_0^{I_q} \frac{U_q(I_d, \tilde{I}_q, I_E) - R_1\tilde{I}_q}{d\tilde{I}_q/dt} d\tilde{I}_q + \int_0^{I_d} \frac{U_q(\tilde{I}_d, 0, I_E)}{d\tilde{I}_d/dt} d\tilde{I}_d + \int_0^{I_E} \frac{U_q(0,0, \tilde{I}_E)}{d\tilde{I}_E/dt} d\tilde{I}_E + \psi_q(0,0,0)$$

$$\psi_E(I_d, I_q, I_E) = \int_0^{I_E} \frac{U_E(I_d, I_q, \tilde{I}_E) - R_2\tilde{I}_E}{d\tilde{I}_E/dt} d\tilde{I}_E + \int_0^{I_d} \frac{U_E(\tilde{I}_d, I_{q,0})}{d\tilde{I}_d/dt} d\tilde{I}_d + \int_0^{I_q} \frac{U_E(0, \tilde{I}_q, 0)}{d\tilde{I}_q/dt} d\tilde{I}_q$$

where $R_1$ and $R_2$ are the ohmic resistances of the corresponding windings of the synchronous machine,
wherein the signal electronics operate the synchronous machine in regulated operation and in so doing set an optimal operating point,

- wherein a target value of the exciting current is ascertained by solving the nonlinear optimisation problem

$$F(I_d, I_q, I_E) = \min!$$

*under the constraint:*

$$M_{target} = M = \frac{m}{2}p\left(\psi_d(I_d, I_q, I_E) I_q - \psi_q(I_d, I_q, I_E) I_d\right),$$

where

M stands for the torque,
$M_{target}$ stands for a desired target value torque,
m stands for the number of phases of the synchronous machine,
p stands for the number of pole pairs of the
synchronous machine
$\psi$ stands for the linked magnetic flux and
F stands for the function to be minimised,
in particular where the value of the variable $I_E$ at the particular minimum of the function F is used as
target value of the exciting current,

- wherein the ascertained target value of the exciting current is used as target value for an exciting current
regulator,
- wherein an instantaneous value of the exciting current is ascertained by measurement or modelling,
- wherein target values of the stator current are ascertained using the ascertained instantaneous value of
the exciting current by solving the nonlinear optimisation problem

$$F(I_d, I_q, I_E) = \text{min!}$$

*under the constraints:*

$$M_{target} = M = \frac{m}{2}p\left(\psi_d(I_d, I_q, I_{E\_inst}) I_q - \psi_q(I_d, I_q, I_{E\_inst}) I_d\right)$$

$$I_E = I_{E\_inst},$$

where

$I_{E\_inst}$ represents the instantaneous value of the exciting current,
in particular where the values of the variables $I_d$ and $I_q$ at the particular minimum of the function F are
used as target values of the stator current, in particular as respective corresponding target values of
the stator current,

- wherein the target values of the stator current are supplied to corresponding stator current regulators, in
particular therefore to a current regulator for $I_d$ and a current regulator for $I_q$,
in particular wherein respective instantaneous values are supplied to these two current regulators, which
values are determined from the detected instantaneous value of the motor current, in particular therefore
of the motor current space phasor,

wherein the function F to be minimised describes the sum of losses, in particular ohmic losses and/or iron losses,
in particular in dependence on the currents $I_d, I_q, I_E$,
in particular wherein the function F to be minimised is formed as the sum of the individual losses associated with
the synchronous machine, in particular converter-fed synchronous machine,
in particular is formed as the sum of model values for stator ohmic losses, rotor ohmic losses, stator iron losses,
rotor iron losses, converter losses and/or transformer losses on supply of the exciting winding by transformer or sliding contact losses on supply of the exciting winding by sliding contact.

**Revendications**

1. Procédé pour commander un point de fonctionnement optimal d'une machine synchrone, en particulier en fonctionnement quasi stationnaire,
   **caractérisé en ce que**
   dans une première étape de procédé selon l'invention, une dépendance fonctionnelle des composantes de tension $U_d$, Uq, $U_E$ par rapport aux composantes de courant $I_d$, $I_q$, $I_E$ est déterminée pour la machine synchrone au moyen d'une méthode FEM ou au moyen d'une méthode de mesure,
   et, à partir de celle-ci, la dépendance respective des composantes d'enchaînement des flux $\psi_d$, $\psi_q$, $\psi_E$ par rapport aux composantes de courant $I_d$, $I_q$, $I_E$ est déterminée selon

$$\psi_d(I_d,I_q,I_E) = \int_0^{I_d} \frac{U_d(\tilde{I}_d,I_q,I_E)-R_1\tilde{I}_d}{d\tilde{I}_d/dt}d\tilde{I}_d + \int_0^{I_E} \frac{U_d(0,I_q,\tilde{I}_E)}{d\tilde{I}_E/dt}d\tilde{I}_E + \int_0^{I_q} \frac{U_d(0,\tilde{I}_q,0)}{d\tilde{I}_q/dt}d\tilde{I}_q + \psi_d(0,0,0)$$

$$\psi_q(I_d,I_q,I_E) = \int_0^{I_q} \frac{U_q(I_d,\tilde{I}_q,I_E)-R_1\tilde{I}_q}{d\tilde{I}_q/dt}d\tilde{I}_q + \int_0^{I_d} \frac{U_q(\tilde{I}_d,0,I_E)}{d\tilde{I}_d/dt}d\tilde{I}_d + \int_0^{I_E} \frac{U_q(0,0,\tilde{I}_E)}{d\tilde{I}_E/dt}d\tilde{I}_E + \psi_q(0,0,0)$$

$$\psi_E(I_d,I_q,I_E) = \int_0^{I_E} \frac{U_E(I_d,I_q,\tilde{I}_E)-R_2\tilde{I}_E}{d\tilde{I}_E/dt}d\tilde{I}_E + \int_0^{I_d} \frac{U_E(\tilde{I}_d,I_q,0)}{d\tilde{I}_d/dt}d\tilde{I}_d + \int_0^{I_q} \frac{U_E(0,\tilde{I}_q,0)}{d\tilde{I}_q/dt}d\tilde{I}_q,$$

$R_1$ et $R_2$ étant les résistances ohmiques des enroulements correspondants de la machine synchrone,
dans une deuxième étape de procédé selon l'invention, la machine synchrone est opérée en fonctionnement régulé et un point de fonctionnement optimal est commandé,

- une valeur de consigne de courant d'excitation étant déterminée par résolution du problème d'optimisation non linéaire

$$F(I_d,I_q,I_E) = \min!$$

*sous la contrainte :*

$$M_{soll} = M = \frac{m}{2}p(\psi_d(I_d,I_q,I_E)I_q - \psi_q(I_d,I_q,I_E)I_d)$$

où

M est le couple,
$M_{soll}$ un couple de consigne souhaité,
m le nombre de phases de la machine synchrone,
p le nombre de paires de pôles de la machine synchrone,
$\psi$ le flux magnétique enchaîné et

F la fonction à minimiser,
la valeur de la variable $I_E$ au minimum déterminé de la fonction F étant en particulier utilisée comme valeur de consigne de courant d'excitation,

- la valeur de consigne de courant d'excitation déterminée étant utilisée comme valeur de consigne pour un régulateur de courant d'excitation,
- une valeur réelle de courant d'excitation étant déterminée par mesure ou modélisation,
- des valeurs de consigne de courant de stator étant déterminées en utilisant la valeur réelle de courant d'excitation déterminée par résolution du problème d'optimisation non linéaire

$$F(I_d, I_q, I_E) = \min!$$

*sous la contrainte :*

$$M_{soll} = M = \frac{m}{2} p(\psi_d(I_d, I_q, I_{E\_ist}) I_q - \psi_q(I_d, I_q, I_{E\_ist}) I_d)$$

où

$$I_E = I_{E\_ist}$$

$I_{E\_ist}$ est la valeur réelle de courant d'excitation,
les valeurs des variables $I_d$ et $I_q$ au minimum déterminé de la fonction F étant en particulier utilisées comme valeurs de consigne de courant de stator, en particulier comme valeurs de consigne de courant de stator correspondantes respectives,

- les valeurs de consigne de courant de stator étant amenées à des régulateurs de courant de stator correspondants, en particulier donc à un régulateur de courant pour $I_d$ et un régulateur de courant pour $I_q$, des valeurs réelles respectives étant en particulier amenées à ces deux régulateurs de courant, qui sont déterminées à partir de la valeur réelle détectée du courant de moteur, en particulier donc du vecteur spatial de courant de moteur,

la fonction F à minimiser décrivant la somme des pertes, en particulier des pertes par effet Joule et/ou des pertes dans le fer, en particulier en fonction des courants $I_d$, $I_q$, $I_E$,
en particulier la fonction F à minimiser étant formée comme somme des pertes séparées dues à la machine synchrone, en particulier à la machine synchrone alimentée par variateur de fréquence,
en particulier étant formée comme somme de valeurs de modèle pour les pertes par effet Joule dans le stator, les pertes par effet Joule dans le rotor, les pertes dans le fer du stator, les pertes dans le fer du rotor, les pertes de variateur de fréquence et/ou les pertes de transformateur en cas d'alimentation de l'enroulement d'excitation par transformateur ou les pertes de contacts frotteurs en cas d'alimentation de l'enroulement d'excitation par contacts frotteurs.

2. Procédé selon au moins une des revendications précédentes,
**caractérisé en ce que**
le problème d'optimisation de la détermination du minimum de la fonction F est résolu numériquement, une valeur étant affectée comme solution à chacun des courants $I_d$, $I_q$, $I_E$ et la valeur affectée au courant $I_E$ étant utilisée comme valeur de consigne de courant d'excitation.

3. Procédé selon au moins une des revendications précédentes,
**caractérisé en ce que**
les contraintes suivantes sont prises en compte dans les problèmes d'optimisation

$$U_d - R_1 I_d + \Omega \psi_q(I_d, I_q, I_E) = 0$$

$$U_q - R_1 I_q + \Omega \psi_d(I_d, I_q, I_E) = 0$$

$$U^2_{Stator\_max} \geq U^2_d + U^2_q$$

où

- Q est la vitesse angulaire électrique,
- $R_1$ la résistance ohmique de l'enroulement de stator,
- $\psi$ le flux magnétique enchaîné et
- $U_{stator\_max}$ la tension de stator maximale admissible.

4. Procédé selon au moins une des revendications précédentes,
**caractérisé en ce que**
la contrainte suivante est prise en compte dans les problèmes d'optimisation

$$I^2_{Stator\_max} \geq I^2_d + I^2_q$$

où $I_{Stator\_max}$ est le courant de stator maximal admissible.

5. Procédé selon au moins une des revendications précédentes,
**caractérisé en ce que**
la tension de stator maximal $U_{Stator\_max}$ est prescrite par un système de régulation supérieur de façon qu'une réserve de régulation minimale des régulateurs de courant de stator soit maintenue.

6. Procédé selon au moins une des revendications précédentes,
**caractérisé en ce que**
la valeur de consigne de courant d'excitation déterminée est limitée à une valeur maximale.

7. Procédé selon au moins une des revendications précédentes,
**caractérisé en ce que**
la limitation de la valeur de consigne de courant d'excitation est réalisée par un modèle de protection thermique.

8. Procédé selon au moins une des revendications précédentes,
**caractérisé en ce que**
la résolution des problèmes d'optimisation non linéaires est réalisée hors ligne, donc pas en fonctionnement régulé, pour plusieurs points et les résultats sont utilisés en fonctionnement régulé sous la forme de tableaux ou de formes de description fonctionnelle.

9. Procédé selon au moins une des revendications précédentes,
**caractérisé en ce que**
une valeur réelle de courant d'excitation est déterminée par mesure ou modélisation.

10. Procédé selon au moins une des revendications précédentes,
**caractérisé en ce que**
en cas de défaillance identifiable de l'excitation, la valeur réelle de courant d'excitation retournée est mise à la valeur nulle.

**11.** Procédé selon au moins une des revendications précédentes,
**caractérisé en ce que**
sur les machines synchrones sans enroulement de champ d'excitation, la valeur de consigne ou la valeur réelle de courant d'excitation n'existe pas et la détermination d'une valeur de consigne ou d'une valeur réelle de courant d'excitation n'a pas lieu.

**12.** Machine synchrone alimentée par variateur de fréquence,
dans laquelle un régulateur pour réaliser le fonctionnement régulé est disposé dans une électronique de signalisation,
dans laquelle des moyens de détection de courant sont reliés électriquement au régulateur et le signal de sortie du régulateur est prévu pour régler la tension pour la machine synchrone,
des signaux de commande modulés en largeur d'impulsion en fonction du signal de sortie étant amenés à des semi-conducteurs de puissance commandables d'un onduleur au moyen de l'électronique de signalisation,
lequel onduleur alimente la machine synchrone,
l'électronique de signalisation commandant un point de fonctionnement optimal d'une machine synchrone, en particulier en fonctionnement quasi stationnaire,
un moyen étant prévu pour déterminer une dépendance fonctionnelle des composantes de tension $U_d$, $U_q$, $U_E$ par rapport aux composantes de courant $I_d$, $I_q$, $I_E$ pour la machine synchrone au moyen d'une méthode FEM ou au moyen d'une méthode de mesure,
et, à partir de celle-ci, la dépendance respective des composantes d'enchaînement des flux $\psi_d$, $\psi_q$, $\psi_E$ par rapport aux composantes de courant $I_d$, $I_q$, $I_E$ est déterminée selon

$$\psi_d(I_d,I_q,I_E) = \int_0^{I_d} \frac{U_d(\widetilde{I}_d,I_q,I_E)-R_1\widetilde{I}_d}{d\widetilde{I}_d/dt}d\widetilde{I}_d + \int_0^{I_E} \frac{U_d(0,I_q,\widetilde{I}_E)}{d\widetilde{I}_E/dt}d\widetilde{I}_E + \int_0^{I_q} \frac{U_d(0,\widetilde{I}_q,0)}{d\widetilde{I}_q/dt}d\widetilde{I}_q + \psi_d(0,0,0)$$

$$\psi_q(I_d,I_q,I_E) = \int_0^{I_q} \frac{U_q(I_d,\widetilde{I}_q,I_E)-R_1\widetilde{I}_q}{d\widetilde{I}_q/dt}d\widetilde{I}_q + \int_0^{I_d} \frac{U_q(\widetilde{I}_d,0,I_E)}{d\widetilde{I}_d/dt}d\widetilde{I}_d + \int_0^{I_E} \frac{U_q(0,0,\widetilde{I}_E)}{d\widetilde{I}_E/dt}d\widetilde{I}_E + \psi_q(0,0,0)$$

$$\psi_E(I_d,I_q,I_E) = \int_0^{I_E} \frac{U_E(I_d,I_q,\widetilde{I}_E)-R_2\widetilde{I}_E}{d\widetilde{I}_E/dt}d\widetilde{I}_E + \int_0^{I_d} \frac{U_E(\widetilde{I}_d,I_q,0)}{d\widetilde{I}_d/dt}d\widetilde{I}_d + \int_0^{I_q} \frac{U_E(0,\widetilde{I}_q,0)}{d\widetilde{I}_q/dt}d\widetilde{I}_q ,$$

$R_1$ et $R_2$ étant les résistances ohmiques des enroulements correspondants de la machine synchrone,
l'électronique de signalisation opérant la machine synchrone en fonctionnement régulé et commandant un point de fonctionnement optimal,

- une valeur de consigne de courant d'excitation étant déterminée par résolution du problème d'optimisation non linéaire

$$F(I_d,I_q,I_E) = \min!$$

*sous la contrainte :*

$$M_{soll} = M = \frac{m}{2} p(\psi_d(I_d, I_q, I_E)I_q - \psi_q(I_d, I_q, I_E)I_d)$$

où

M est le couple,
M$_{soll}$ un couple de consigne souhaité,
m le nombre de phases de la machine synchrone,
p le nombre de paires de pôles de la machine synchrone,
$\psi$ le flux magnétique enchaîné et
F la fonction à minimiser,
la valeur de la variable $I_E$ au minimum déterminé de la fonction F étant en particulier utilisée comme valeur de consigne de courant d'excitation,

- la valeur de consigne de courant d'excitation déterminée étant utilisée comme valeur de consigne pour un régulateur de courant d'excitation,
- une valeur réelle de courant d'excitation étant déterminée par mesure ou modélisation,
- des valeurs de consigne de courant de stator étant déterminées en utilisant la valeur réelle de courant d'excitation déterminée par résolution du problème d'optimisation non linéaire

$$F(I_d, I_q, I_E) = \min!$$

sous la contrainte :

$$M_{soll} = M = \frac{m}{2} p(\psi_d(I_d, I_q, I_{E\_ist})I_q - \psi_q(I_d, I_q, I_{E\_ist})I_d)$$

où

$$I_E = I_{E\_ist}$$

I$_{E\_ist}$ est la valeur réelle de courant d'excitation,
les valeurs des variables $I_d$ et $I_q$ au minimum déterminé de la fonction F étant en particulier utilisées comme valeurs de consigne de courant de stator, en particulier comme valeurs de consigne de courant de stator correspondantes respectives,

- les valeurs de consigne de courant de stator étant amenées à des régulateurs de courant de stator correspondants, en particulier donc à un régulateur de courant pour $I_d$ et un régulateur de courant pour $I_q$, des valeurs réelles respectives étant en particulier amenées à ces deux régulateurs de courant, qui sont déterminées à partir de la valeur réelle détectée du courant de moteur, en particulier donc du vecteur spatial de courant de moteur,

la fonction F à minimiser décrivant la somme des pertes, en particulier des pertes par effet Joule et/ou des pertes dans le fer, en particulier en fonction des courants $I_d$, $I_q$, $I_E$,
en particulier la fonction F à minimiser étant formée comme somme des pertes séparées dues à la machine synchrone, en particulier à la machine synchrone alimentée par variateur de fréquence,
en particulier étant formée comme somme de valeurs de modèle pour les pertes par effet Joule dans le stator, les pertes par effet Joule dans le rotor, les pertes dans le fer du stator, les pertes dans le fer du rotor, les pertes de variateur de fréquence et/ou les pertes de transformateur en cas d'alimentation de l'enroulement d'excitation par transformateur ou les pertes de contacts frotteurs en cas d'alimentation de l'enroulement d'excitation par contacts frotteurs.

$I_{q\_soll}$

$+$

$-$

$I_{q\_ist}$

$I_{d\_soll}$

$+$

$-$

$I_{d\_ist}$

$U_{q\_soll}$

$U_{d\_soll}$

Berechnung der
Ansteuersignale der
Leistungshalbleiter

abc

dq

**FIG 1**

FIG 2

FIG 3

EP 2 553 802 B1

FIG 4

31

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20080052059 A1
- DE 19833953 A1
- US 20050137834 A1

**In der Beschreibung aufgeführte Nicht-Patentliteratur**

- **VON BAUSCH ; ZENG ; KANELIS.** Feed -forward control of current excited synchronous drives. *ICEM '94, CONFERENCE INTERNATIONALE SUR LE MACHINES ELEKTRIQUES; INTERNATIONAL CONFERENCE ON ELECTRICAL MACHINES; 5-8,SEPTEMBRE/SEPTEMBER, PALAIS DES CONGRES, PARIS, FRANCE, SOCIETE DES ELECTRICIENS ET DES ELECTRONICIENS, PARIS; THE INSTITUTI,* 05. September 1994, vol. 1, 220-225